# EUROPEAN PATENT APPLICATION

(11) **EP 3 324 481 A1**
(43) Date of publication of application: **23.05.2018**
(21) Application number: 16199740.8
(22) Date of filing: 21.11.2016
(51) Int. Cl.: H01P 3/16, H05K 9/00

(54) **METHOD FOR MANUFACTURING A DIELECTRIC-FILLED METAL WAVEGUIDE**

(71) Applicant: TE Connectivity Nederland B.V., 5222 AR's-Hertogenbosch (NL)
(72) Inventor: SINAGA, Saoer Maniur, 3544 Utrecht (NL); ROUSSTIA, Mohadig Widha, 5612 Eindhoven (NL); HORNUNG, Rainer Oliver, 5223 's-Hertogenbosch (NL); PANIS, Martinus E.J.J., 5275 Den Dungen (NL); HABRAKEN, Gied, 5551 HX Valkenswaard (NL); MAAS, Mark, 5708 TT Helmond (NL)
(74) Representative: Grünecker Patent- und Rechtsanwälte PartG mbB

(57) **Abstract**

The present invention relates to a method for manufacturing a dielectric-filled metal waveguide, and to a corresponding dielectric-filled metal waveguide. A method for manufacturing a dielectric-filled metal waveguide (100), comprises the steps of providing a core material (110) comprising a dielectric medium; selecting a heat shrink tube (102) comprising an electrically insulating material, preferably having an inner layer (106) and an outer layer (104), wherein said heat shrink tube (102) comprises metal particles (108), and wherein the heat shrink tube (102) has a pre-expanded first inner diameter which is less than an outer diameter (d) of said core material (110), and is expanded so that it has a second inner diameter (D) greater than the outer diameter of the core; jacketing the core material (110) with the heat shrink tube (102); and applying heat to the heat shrink tube (102) effective to shrink the heat shrink tube (102) around the outer periphery of the core material (110), and further effective to adhesively bond at least a portion of the heat shrink tube (102) to the outer periphery of the core material (110).

## Description

The present invention relates to a method for manufacturing a dielectric-filled metal waveguide, and to a corresponding dielectric-filled metal waveguide.

Dielectric-filled metal waveguides are used in communication applications to convey signals in the form of electromagnetic waves along a path. Dielectric-filled metal waveguides provide communication transmission lines for connecting communication devices, such as connecting an antenna to a radio frequency transmitter and/or receiver, providing a board-to-board communication, an industrial communication, a sub-sea communication, a backhaul communication, etc. Although waves in open space propagate in all directions, dielectric-filled metal waveguides generally confine the waves and direct the waves along a defined path, which allows the waveguides to transmit high frequency signals over relatively long distances. The present invention is particularly advantageous when transmitting signals via millimeter wave signals over so-called polymer millimeter wave fibers (PMF, also called plastic waveguides in the following). In the context of the present invention the millimeter wave frequency range is referring to signals with a frequency between 30 GHz and 300 GHz, for instance 60 GHz. By making use of carrier frequencies in this frequency domain, wide band communication systems benefit from the large bandwidth available.

Dielectric-filled metal waveguides include at least one dielectric material in solid or foamed form, and typically have two or more dielectric materials. A dielectric is an electrical insulating material that can be polarized by an applied electrical field. The polarizability of a dielectric material is expressed by a value called the dielectric constant or relative permittivity. The dielectric constant of a given material is its dielectric permittivity expressed as a ratio relative to the permittivity of a vacuum, which is 1 by definition. A first dielectric material with a greater dielectric constant than a second dielectric material or vice versa can be used to confine the waves.

Some known dielectric-filled metal waveguides include a core dielectric material and a cladding dielectric material that surrounds the core dielectric material. The dielectric constants, in addition to the dimensions and other parameters, of each of the core dielectric material and the cladding dielectric material affect how an electromagnetic field through the waveguide is distributed within the waveguide. In known dielectric-filled metal waveguides, the electromagnetic field typically has a distribution that extends radially through the core dielectric material, the cladding dielectric material, and even partially outside of the cladding dielectric material (for example, within the air outside of the waveguide).

There are several issues associated with portions of the electromagnetic field extending outside of the cladding of the dielectric-filled metal waveguide into the surrounding environment. First, the portions of the electromagnetic field outside of the waveguide may produce high crosstalk levels when multiple dielectric-filled metal waveguides are bundled together in a cable, and the level of crosstalk increases with higher modulated frequencies propagating through the waveguides. Second, some electromagnetic fields in air may travel faster than fields that propagate within the waveguide, which leads to the undesired electrical effect called dispersion. Dispersion occurs when some frequency components of a signal travel at a different speed than other frequency components of the signal, resulting in inter-signal interference. Third, the dielectric-filled metal waveguide may experience interference and signal degradation due to external physical influences that interact with the electromagnetic field, such as a human hand touching the dielectric-filled metal waveguide. Finally, portions of the electromagnetic field outside of the waveguide may be lost along bends in the waveguide, as uncontained fields tend to radiate away in a straight line instead of following the contours of the waveguide.

One potential solution for at least some of these issues is to increase the overall diameter of the dielectric-filled metal waveguides, such as by increasing the diameter of the cladding layer or the diameter of a dielectric outer jacket layer that surrounds the cladding layer. Increasing the amount of dielectric material provides better field containment and reduces the amount or extent of the electromagnetic field propagating outside of the waveguide. But, increasing the size of the dielectric-filled metal waveguide introduces other drawbacks, including reduced flexibility of the waveguides, increased material costs, and a reduced number of waveguides that can fit within a given area or space (for example, reducing the density of waveguides).

Another potential solution is to provide an electrically conductive shielding layer that engages the outer dielectric layers of the waveguide and surrounds the full perimeter of the waveguide. But, completely encasing the dielectric-filled metal waveguide with a conductive material can cause undesirably high energy loss levels (for example, insertion loss and/or return loss) in the waveguides as portions of the electromagnetic fields induce surface currents in the conductive material. High loss levels shorten the effective length that an electromagnetic wave will propagate through the waveguide. Furthermore, outer massive metal shielding layers interacting with the propagating electromagnetic waves can allow undesirable modes of propagation that have hard cutoff frequencies. For example, at some specific frequencies, the shielding layers can completely halt or "cutoff" the desired field propagation. Finally, thick solid metal shielding can negatively affect flexibility.

Therefore, a flexible thin metal shielding layer is preferable. Thin metal coated shielding tubes are commonly used to shield electrical wires from external electromagnetic radiation. Such shielding tubes employ a metal coated heat shrink tube which can be easily fitted around an electric wire or bundle of wires and fixed thereto by a heating process.

In detail, a heat shrink tube is a rubber or plastic tube which shrinks in all dimensions when exposed to heat. Such tubes are used to protect or fix electric wires or cables inserted within the tube. The tube generally has a seamless tubular shape. The tubes are made of material such as polyolefin, polytetrafluoroethylene or polyvinyl chloride (PVC). When an electric wire or cable is inserted into the shielding tube and heat is applied, the tube constricts, causing the inner surface of the tube to tightly engage the outside surface of the electric wires within in order to protect and fix them. Furthermore, a heat shrinkable shield tube comprises an outer tube comprising a heat shrinkable material and an inner shielding layer which is a sheet of electromagnetic shielding material extending around the entire internal circumference of the tube. An adhesive attaches the sheet of shielding material to the interior of the tube.

A heat shrinkable tube is obtained by melting and extruding a rubber or plastic material such as polyethylene, polyvinyl chloride or polyester in a tubular form. The obtained tube may be irradiated with an electron beam, thereby cross linking the material. The cross linked tube is then stretched at a temperature lower than the melting point of the material, but higher than its softering point. Upon heating, a heat shrinkable tube prepared in this manner is capable of returning to its original shape prior to stretching. Such a tube may be used to form a tight rubber or plastic covering on a desired object, such as a waveguide.

A method for forming a heat shrinkable shielding tube first involves placing a sheet of electromagnetic shielding material around a cylinder so that the sheet of shielding material is formed into a cylindrical shape. The cylinder and the sheet of electromagnetic shielding material are inserted through a length of heat shrinkable tube. A portion of the sheet of electromagnetic shielding material is adhesively bonded to an internal surface of the heat shrinkable tube before the cylinder is removed.

A need remains for a dielectric-filled metal waveguide for propagating high frequency electromagnetic signals that has a relatively compact size and a reduced sensitivity to external influences (for example, crosstalk and other interference), while providing acceptably low levels of loss and avoiding unwanted mode propagation, that can be realized at low cost and that is robust and reliable even under harsh environmental conditions such as for automotive and industrial applications.

This object is solved by the subject matter of the independent claims. Advantageous embodiments of the present invention are the subject matter of the dependent claims.

The present invention is based on the idea to fabricate a dielectric-filled metal waveguide using a metal coated heat shrink tube for applying a metal layer around the dielectric fiber material. In particular, a method for manufacturing a dielectric-filled metal waveguide, comprising the steps of providing a core comprising a dielectric medium; selecting a heat shrink tube comprising an electrically insulating material comprising an inner layer only, or an inner layer and an outer layer; wherein said heat shrink tube has metal particles embedded therein (preferably embedded in an inner layer comprising an adhesive material). The heat shrink tube has a pre-expanded first inner diameter which is less than an outer diameter of said core, and is expanded so that it has a second inner diameter greater than the outer diameter of the core; jacketing the core with the heat shrink tube; and applying heat to the heat shrink tube effective to shrink the heat shrink tube around the outer periphery of the core, and further effective to adhesively bond at least a portion of the heat shrink tube to the outer periphery of the core. In case that a two layer structure with an inner adhesive layer is used, the adhesive layer is also adhesively bonded to the inner periphery of the outer layer of the heat shrink tube.

The advantages of this fabrication method can be seen in an economic fabrication, and a high quality of the metallization layer. At the same time, the waveguide still maintains its flexibility, so that it can be stored in tight spaces. In particular, by embedding metal particles in a polymer matrix a high flexibility of the waveguide can be achieved. Bending a solid metal cylinder with a diameter of about 5 mm may cause it to crack and/or buckle. According to the present invention, the metal particles are in a compliant matrix material so that this disadvantage can be prevented. Furthermore, the electrically conductive layer needs to be smooth and without gaps or scratches and the method according to the present invention may achieve this.

According to an advantageous embodiment, the adhesively bonding of the adhesive layer further comprises including at least one phase transition of the adhesive layer. In particular, the at least one phase transition of the adhesive layer further comprises a change from a solid phase of the adhesive layer to a liquid phase of the adhesive layer when applying heat to the adhesive layer. This allows pre-fabricating the heat shrink tube and keeping it in stock because the adhesive layer does not function as an adhesive before being brought in place around the core material.

In order to ensure a tight and secure fit of the metal particle containing layer around the core, also sealing against the intrusion of moisture, the adhesive layer passes from the liquid phase to a solid phase when cooling down after the shrinking step. Preferably, the adhesive material also chemically anneals during the solidifying process in order to be particularly stable. According to the present invention, the metal particles embedded in the adhesive layer comprise silver, copper, gold, platinum, and/or a mixture of these metals. Such noble metals exhibit an excellent electric conductivity and, furthermore, do not easily corrode.

The present invention further relates to a dielectric-filled metal waveguide, the waveguide comprising a core which comprises a dielectric medium. A heat shrink tube comprising an inner layer and an outer layer is shrunk to encompass the core. The inner layer of the heat shrink tube comprises an adhesive layer containing metal particles wherein at least a portion of the adhesive layer is adhesively bonded to the outer periphery of the core and the inner periphery of the outer layer of the heat shrink tube, respectively. As already mentioned above, this technique allows providing a metal shield around the dielectric core material, while still maintaining a high degree of flexibility and bendability.

Advantageously, the dielectric core material further comprises a polymer material, for instance polyethylene (PE), polypropylene (PP), and/or polytetrafluoroethylene (PTFE, trademark "Teflon").

The advantages of the present invention may be realized for instance when shrinking the heat shrink tube around a core material that comprises a solid core or a foamed core.

In order to improve the waveguide's characteristics, the core may further comprise at least one cladding layer. For instance, the at least one cladding layer comprises a foamed cladding or a solid cladding.

As this is clear for a person skilled in the art, any suitable cross-sectional shape of the core material can be combined with a heat shrink tube according to the present invention because due to the heat shrink process the metal containing inner layer always smoothly follows the circumferential outline of the peripheral surface of the core material. For instance, the core material may comprise a cross-section with a circular, an elliptical, or a polygonal shape.

According to the present invention, the metal particles embedded in the adhesive layer comprise silver, copper, gold, platinum, and/or a mixture of these metals. Such noble metals exhibit an excellent electric conductivity and, furthermore, do not easily corrode. The surface roughness and distance between the metal particles which are dispersed in the insulating material of the adhesive layer determine the quality of the dielectric-filled metal waveguide. These parameters can be optimized according to the common knowledge of a person skilled in the art.

The accompanying drawings are incorporated into the specification and form a part of the specification to illustrate several embodiments of the present invention. These drawings, together with the description, serve to explain the principles of the invention. The drawings are merely for the purpose of illustrating the preferred and alternative examples of how the invention can be made and used, and are not to be construed as limiting the invention to only the illustrated and described embodiments.

Furthermore, several aspects of the embodiments may form-individually or in different combinations-solutions according to the present invention. Further features and advantages will be become apparent from the following more particular description of the various embodiments of the invention as illustrated in the accompanying drawings, in which like references refer to like elements, and wherein:
- **FIG. 1**: is a schematic sectional of a heat shrink tube according to the present invention;
- **FIG. 2**: is a schematic sectional view of dielectric-filled metal waveguide according to a first embodiment of the present invention;
- **FIG. 3**: is a schematic sectional view of dielectric-filled metal waveguide according to a second embodiment of the present invention;
- **FIG. 4**: is a schematic diagram of a fabrication process according to the present invention.

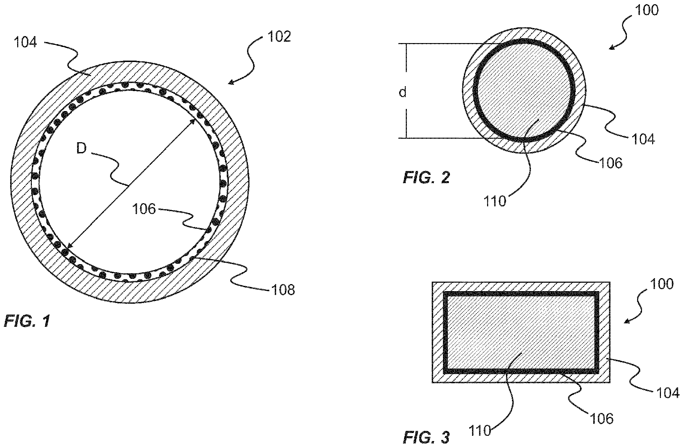

The present invention will now be explained in more detail with reference to the Figures. Referring to Fig. 1, a heat shrink tube 102 according to the present invention is shown in an expanded state. The heat shrink tube 102 comprises an outer layer 104 and an inner layer 106. The outer layer 104 is formed from a heat shrink material that returns to a shape with a smaller diameter under the influence of heat. As this is generally known to a person skilled in the art, the heat shrink tube 102 in the expanded state has an inner diameter D that is larger than the outer diameter d of a core material (see Fig. 2) around which it is shrunk in the final mounted state. It should be noted that none of the Figures are drawn to scale in order to more clearly explain the components being part of the inventive concept.

According to the present invention, the inner layer 106 is filled with metal particles 108. Preferably, these metal particles 108 comprise silver, copper, gold, platinum, and/or a mixture of these metals. Furthermore, other suitable electrically conductive particles can also be used according to the present invention.

The inner layer 106 advantageously comprises an adhesive material which, in the mounted state, adheres to the outer surface of the core material as well as to the inner surface of the outer layer 104.

The heat shrink tube 102 shown in Fig. 1 is shrunk to fit around a core material 110 (also called polymer fiber in the following) as this is shown in Fig. 2. The shrinking is performed by applying heat to the heat shrink tube 102, whereby the inner diameter D is reduced to a value that is smaller than the outer diameter d of the core material 110. Hence, a close fitting of the metal coated heat shrink tube 102 around the core material 110 is ensured.

Moreover, due to the thermal action of the shrinking step, the adhesive material of the inner layer 106 liquefies (or at least softens) and hardens again after cooling. Thereby, a firm connection between the outer surface of the core material 110 and the inner surface of the outer layer 104 is achieved. The metal particles 108 dispersed in the inner layer 106 are compressed between the core material 110 and the outer layer 104. According to an advantageous embodiment, the adhesive is chemically cured (for instance cross-linked) by the influence of the heat applied during the shrinking step.

In Fig. 2, the core material 110 is shown to be formed by one single material. It can be fabricated from a solid polymer or from a foamed polymer. However, the waveguide 100 may additionally comprise one or more cladding layers (not shown in the Figures) that surround the core material 110 within the metal coated heat shrink tube 102. As this is clear for a person skilled in the art, the technique according to the present invention can be used for single-mode as well as multi-mode propagation. The polymer fiber itself may have a solid core with one or more (optional) solid or foamed cladding layers or any other advantageous structure. The polymer materials can be based on any suitable polymer material, for instance polyethylene (PE), polypropylene (PP), and/or polytetrafluoroethylene (PTFE, trademark "Teflon").

The heat shrink tube 102 may also be used together with core materials 110 that have other cross-sectional form than the circular shape shown in Fig. 2. Fig. 3 shows as a further advantageous embodiment a core material 110 having a rectangular cross-section. In this case, the inner diameter D of the heat shrink tube 102 has to be large enough to fit around the diagonal between two corners of the rectangle. Generally spoken, the circumference of the inner surface of the heat shrink tube 102 has to be sufficiently longer than the circumference of the core material 110 in order to allow the heat shrink tube 102 being slid around the core material 110 prior to performing the heat shrink step.

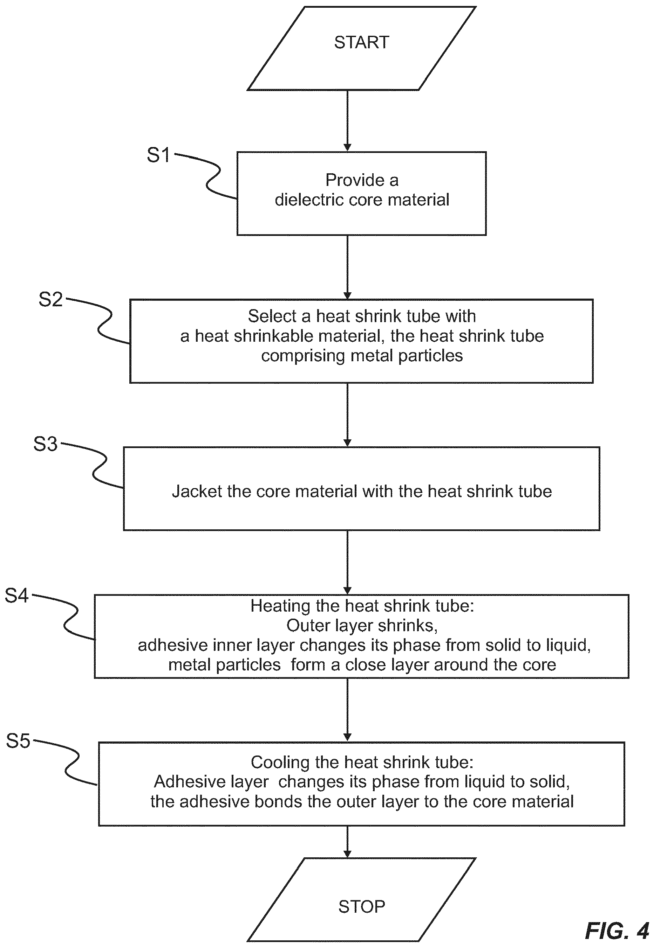

Fig. 4 illustrates the steps that are performed when fabricating the dielectric-filled metal waveguide according to the present invention.

In step S1, a dielectric core material is provided.

Next, in step S2, a heat shrink tube is selected, which has an inner layer made of an adhesive layer with metal particles, and an outer layer made of heat shrinkable material. Alternatively (or additionally), the heat shrinkable material itself may also be filled with metal particles and may also form the only layer of the heat shrinkable tube.

In step S3, the heat shrink tube is slid over the core material in an axial direction to jacket the core material.

Step S4 comprises the actual heating step where the outer layer shrinks and the adhesive inner layer changes its phase from solid to liquid, and where the metal particles form a close layer around the core material.

Finally, in step S5 the complete arrangement is cooled down again, so that the adhesive inner layer solidifies again. Preferably, a chemical cross-linking process takes places so that the adhesive with the embedded metal particles firmly bonds the outer layer to the core material.

In summary, the present invention allows an easy manufacturing of high-quality dielectric-filled metal waveguides for single-mode and multi-mode electromagnetic wave propagation. Applications include but are not limited to board-to-board communication, industrial communication, sub-sea communication, or so-called backhaul networks, i. e. the networks that occupy the intermediate link ("middle mile") in the hierarchy of telecommunication networks between core network and small subnets on the edge of the whole network.

### REFERENCE NUMERALS

| **Reference Numeral** | **Description** |
|---|---|
| 100 | Dielectric-filled metal waveguide |
| 102 | Heat shrink tube |
| 104 | Polymer outer layer |
| 106 | Adhesive inner layer with metal particles |
| 108 | Metal particles |
| 110 | Core material (polymer millimeter fiber, PMF) |

## Claims

1. A method for manufacturing a dielectric-filled metal waveguide (100), comprising the steps of:
providing a core material (110) comprising a dielectric medium;
selecting a heat shrink tube (102) comprising an electrically insulating material with metal particles (108);
wherein the heat shrink tube (102) has a pre-expanded first inner diameter which is less than an outer diameter (d) of said core material (110), and is expanded so that it has a second inner diameter (D) greater than the outer diameter (d) of the core material (110);
jacketing the core material (110) with the heat shrink tube (102); and
applying heat to the heat shrink tube (102) effective to shrink the heat shrink tube (102) around the outer periphery of the core material (110), and further effective to adhesively bond at least a portion of the heat shrink tube (102) to the outer periphery of the core material (110).

2. The method according to claim 1, wherein the heat shrink tube (102) comprises an inner layer (106) and an outer layer (104), wherein said inner layer (106) comprises an adhesive material with said metal particles (108) embedded therein.

3. The method according to claim 2, wherein the adhesively bonding of the adhesive inner layer (106) further comprises including at least one phase transition of the adhesive inner layer (106).

4. The method according to claim 3, wherein the at least one phase transition of the adhesive inner layer (106) further comprises a change from a solid phase of the adhesive inner layer (106) to a liquid phase of the adhesive inner layer (106) when applying heat to the adhesive inner layer (106).

5. The method according to claim 4, further comprising a phase transition from a liquid phase of the adhesive inner layer (106) to a solid phase of the adhesive inner layer (106) when cooling the adhesive inner layer (106).

6. The method according to one of claims 1 to 5, wherein the metal particles (108) comprise silver, copper, gold, platinum, and/or a mixture of metals.

7. A dielectric-filled metal waveguide, comprising:
a core material (110) which comprises a dielectric medium;
a heat shrink tube (102) being shrunk to encompass the core material (110);
wherein the heat shrink tube (102) comprises an insulating material with metal particles (108) embedded therein, wherein at least a portion of the heat shrink tube (102) is adhesively bonded to the outer periphery of the core material (110).

8. The dielectric-filled metal waveguide according to claim 7, wherein the heat shrink tube (102) comprises an adhesive inner layer (106) and an outer layer (104), wherein the adhesive inner layer (106) contains said metal particles (108).

9. The dielectric-filled metal waveguide according to claim 7 or 8, wherein the dielectric core material (110) further comprises a polymer material.

10. The dielectric-filled metal waveguide according to claim 9, wherein the polymer material comprises polyethylene (PE), polypropylene (PP), and/or polytetrafluoroethylene (PTFE).

11. The dielectric-filled metal waveguide according to one of claims 7 to 10, wherein the core material (110) comprises a solid core or a foamed core.

12. The dielectric-filled metal waveguide according to one of claims 7 to 11, wherein the core material (110) further comprises at least one cladding layer.

13. The dielectric-filled metal waveguide according to claim 12, wherein at least one cladding layer comprises a foamed cladding or a solid cladding.

14. The dielectric-filled metal waveguide according to one of claims 7 to 13, wherein the core material (110) comprises a cross-section with a circular, an elliptical, or a polygonal shape.

15. The dielectric-filled metal waveguide according to one of claims 7 to 14, wherein the metal particles (108) comprise silver, copper, gold, platinum, and/or a mixture of these metals.
